**Europäisches Patentamt**

**European Patent Office**

**Office européen des brevets**

(11) Veröffentlichungsnummer: **0 275 995**
**A2**

(12) **EUROPÄISCHE PATENTANMELDUNG**

(21) Anmeldenummer: 88100793.4

(22) Anmeldetag: 20.01.88

(51) Int. Cl.⁴: **H 03 K 17/10**

(30) Priorität: 23.01.87 DE 3701991

(43) Veröffentlichungstag der Anmeldung:
27.07.88 Patentblatt 88/30

(84) Benannte Vertragsstaaten:
AT BE CH DE FR GB IT LI NL SE

(71) Anmelder: **Siemens Aktiengesellschaft Berlin und München**
**Wittelsbacherplatz 2**
**D-8000 München 2 (DE)**

(72) Erfinder: **Von Sichart, Frithjof, Dr. rer. nat.**
**Karl-Theodor-Strasse 72**
**D-8000 München 40 (DE)**

**Von Kirchbauer, Heinrich, Dipl.-Ing.**
**Rumfordstrasse 8**
**D-8000 München 5 (DE)**

(54) **Open-Drain-MOSFET-Schaltung.**

(57) In einer Open-Drain-MOSFET-Schaltung mit einem an seiner Gate-Elektrode mit einem Durchschalte- bzw. Sperrsignal beaufschlagten MOS-Feldeffekttransistor ist zur Verringerung der an diesem im Sperrzustand auftretenden Drain-Gate-Spannung zwischen den MOS-Transistor und einem mit dessen Drain-Elektrode verbundene Speisespannungsquelle mit die Drain-Gate-Durchbruchsspannung des MOS-Feldeffekttransistors überschreitender Speisespannung ein zusätzlicher MOS-Feldeffekttransistor eingefügt, dessen Gate-Elektrode an einer festen, die genannte Drain-Gate-Durchbruchsspannung nicht überschreitenden Betriebsspannung liegt. Zur weiteren Spannungsverringerung kann zwischen den zusätzlichen MOS-Feldeffekttransistor und die Speisespannungsquelle wenigstens ein weiterer MOS-Feldeffekttransistor eingefügt sein, dessen Gate-Elektrode mit seiner Drain-Elektrode zusammengeschaltet ist.

FIG 2

## Beschreibung

Open-Drain-MOSFET-Schaltung

Die Erfindung bezieht sich auf Open-Drain-MOSFET-Schaltungen, d.h. auf MOS-Schaltungen, die als Ausgangsstufe lediglich einen MOS-Feldeffekttransistor aufweisen, dessen Source-Elektrode an Masse liegt.

Open-Drain-Ausgangsstufen lassen sich üblicherweise nur mit einer Speisespannung betreiben, die die Drain-Gate-Durchbruchsspannung des die Ausgangsstufe bildenden MOS-Feldeffekttransistors nicht überschreitet; höhere Speisespannung würden bei gesperrtem Transistor zu Durchbrüchen des Gateoxyds und damit zu dessen Zerstörung führen. Es ist daher nicht ohne weiteres möglich, beispielsweise ein eine Speisespannung von 12 V benötigendes Relais etwa über einen Emitterfolger direkt von einem Open-Drain-Ausgang einer (C-)MOS-Schaltung her anzusteuern, deren Drain-Gate-Durchbruchsspannung beispielsweise bei 8 V liegt.

Man könnte dem durch eine Erhöhung der Drain-Gate-Durchbruchsspannung ausweichen, was indessen besondere, sehr aufwendige Herstellungsprozeduren bedingt. Ähnlich aufwendig wäre auch eine externe Beschaltung einer Open-Drain-Ausgangsstufe mit einer nachfolgenden Pegelumsetzschaltung.

Die Erfindung zeigt demgegenüber einen Weg zu einer nur wenig aufwenigen Open-Drain-Ausgangsschaltung mit einer die Drain-Gate-Durchbruchsspannung übersteigenden Spannungsbelastbarkeit.

Die Erfindung betrifft eine Open-Drain-MOSFET-Schaltung mit einem an seiner Gate-Elektrode mit einem Durchschalte- bzw. Sperrsignal beaufschlagten MOS-Feldeffekttransistor; diese Schaltung ist erfindungsgemäß dadurch gekennzeichnet, daß zwischen den MOS-Feldeffekttransistor und eine mit dessen Drain-Elektrode verbundene Speisespannungsquelle mit die Drain-Gate-Durchbruchsspannung des MOS-Feldeffekttransistors überschreitender Speisespannung ein zusätzlicher MOS-Feldeffekttransistor eingefügt ist, dessen Gate-Elektrode an einer festen, die genannte Drain-Gate-Durchbruchsspannung nicht überschreitenden Betriebsspannung liegt.

Die Erfindung bringt den Vorteil einer ohne großen schaltungstechnischen Aufwand erreichten höheren, eine durch die Drain-Gate-Durchbruchsspannung gegebene Grenze überschreitenden Spannungsbelastbarkeit einer Open-Drain-Ausgangsschaltung mit sich.

Diese Spannungsbelastbarkeit läßt sich dadurch weiter erhöhen, daß in weiterer Ausgestaltung der Erfindung zwischen den zusätzlichen MOS-Feldeffekttransistor und die Speisespannungsquelle wenigstens ein weiterer MOS-Feldeffekttransistor eingefügt ist, dessen Gate-Elektrode mit seiner Drain-Elektrode zusammengeschaltet ist.

Anhand der Zeichnungen sei die Erfindung noch näher erläutert. Dabei zeigen

FIG 1 das schaltungstechnische Prinzip der Ansteuerung eines im Ausgangskreis eines Bipolar-Transistors liegenden Relais durch eine gewöhnliche Open-Drain-MOSFET-Schaltung;

FIG 2 zeigt das Prinzip einer solchen Ansteuerung durch eine Open-Drain-MOSFET-Schaltung gemäß der Erfindung, und

FIG 3 zeigt eine solche Ansteuerung in einer weiteren Ausgestaltung.

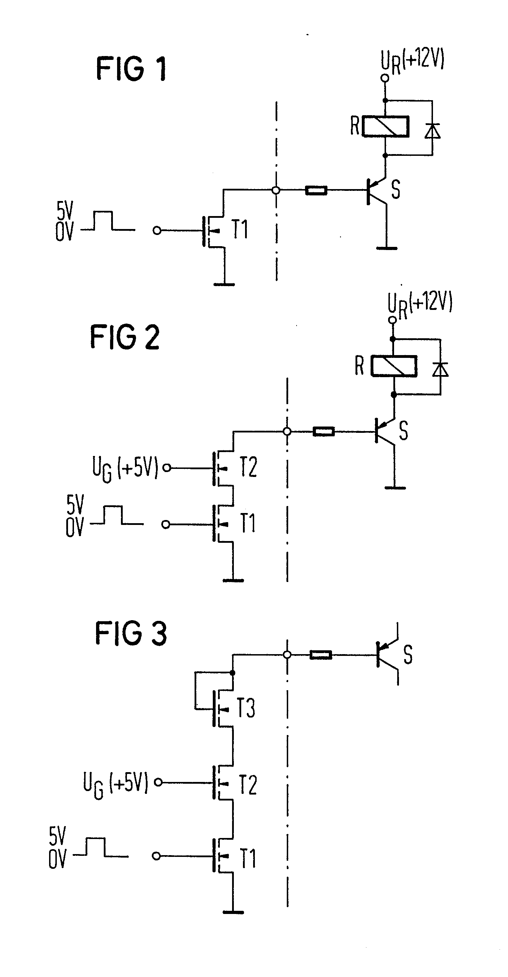

In FIG 1 ist eine Relaisschaltung mit einem im Ausgangskreis eines mit einem bipolaren Transistor S gebildeten Emitterfolgers liegenden Relais R dargestellt, das eine Speisespannung $U_R$ benötigen möge; die Relaisschaltung wird dabei von einer Open-Drain-Ausgangsstufe mit einem MOS-Feldfekttransistor T1 vom Anreicherungstyp gesteuert, dessen Drain-Elektrode über einen Widerstand zur Basis-Elektrode des bipolaren Transistors S führt.

Wird an die Gate-Elektrode des MOS-Feldeffekttransistors T1 (in FIG 1) ein Durchschaltepotential von z. B. +5 V angelegt, so wird der MOS-Feldfekttransistor T1 leitend (Durchlaßzustand) mit der Folge, daß auch der bipolare Transistor S leitend wird, so daß das Relais R aktiviert wird.

Wird an die Gate-Elektrode des MOS-Feldeffekttranstors T1 (in FIG 1) ein Sperrpotential von beispielsweise 0 V angelegt, so wird der MOS-Feldeffekttransistor T1 gesperrt (Sperrzustand) mit der Folge, daß auch der bipolare Transistor S gesperrt wird, so daß das Relais R in den Ruhezustand gelangt. Dabei baut sich das an der Speisespannungsklemme $U_R$ herrschende Potential an der Drain-Elektrode des MOS-Feldeffekttransistor T1 auf.

Geht man nun von einer erforderlichen Relaisspeisespannung $U_R$ von beispielsweise +12 V und einer Drain-Gate-Durchbruchsspannung des MOS-Feldeffekttransistors T1 von etwa 8 V aus, so kommt es hier zu Spannungsdurchbrüchen; das Gateoxyd wird zerstört.

Um dies zu vermeiden, ist in der in FIG 2 skizzierten Schaltungsanordnung gemäß der Erfindung zwischen den MOS-Feldeffekttransistor T1 und eine mit dessen Drain-Anschluß - gemäß FIG 2 über ein Relais R, einen Bipolar-Transistor S und einen Widerstand - verbundene Speisespannungsquelle $U_R$, deren Speisespannung die Drain-Gate-Durchbruchsspannung des MOS-Feldeffekttransistors T1 überschreiten möge, ein zusätzlicher MOS-Feldeffekttransistor T2 eingefügt, dessen Gate-Elektrode an einer festen, die genannte Drain-Gate-Durchbruchsspannung nicht überschreitenden Betriebsspannung $U_G$ liegt.

Wird an die Gate-Elektrode des MOS-Feldeffekttransistors T1 (in FIG 2) ein Durchschaltepotential von z. B. +5 V angelegt, so wird wieder der MOS-Feldeffekttransistor T1 leitend (Durchlaßzustand) mit der Folge, daß das Source-Potential (0 V, Masse) auch am Drain-Anschluß des MOS-Feldfekttransistors T1 und damit am Source-Anschluß des zusätzlichen MOS-Feldeffekttransistors T2 auftritt, der somit ebenfalls leitend ist. Damit wird wiederum auch der bipolare Transistor S leitend, und das Relais R wird aktiviert.

Wird an die Gate-Elektrode des MOS-Feldeffekttransistors T1 (in FIG 2) ein Sperrpotential von beispielsweise 0 V angelegt, so wird der MOS-Feldeffekttransistor T1 wieder gesperrt. Infolgedessen kommt es zunächst wieder von der im Beispiel ein Potential von +12 V führenden Speisespannungsklemme $U_R$ her zu einem Potentialanstieg am Drain-Anschluß des MOS-Feldeffekttransistors T1. Sobald hier indessen etwa die Höhe des an die Gate-Elektrode des zusätzlichen MOS-Feldeffekttransistors T2 fest angeschalteten Betriebspotentials $U_G$ von beispielsweise +5 V erreicht ist, wird auch der zusätzliche MOS-Feldeffekttransistor T2 gesperrt. Am Verbindungspunkt der beiden MOS-Feldeffekttransistoren T1 und T2 verbleibt es damit bei einem Potential von beispielsweise +4,5 V, das gleich der Differenz zwischen dem festen Gate-Potential ($U_G$) des zusätzlichen MOS-Feldeffekttransistors T2 und dessen Schwellenspannung (etwa 1 V) ist. Damit ist auch am MOS-Feldeffekttransistor T1 die Drain-Gate-Spannung auf einen entsprechenden Wert von im Beispiel 4,5 V festgelegt, der weit von der Durchbruchsgrenze entfernt ist. Am zusätzlichen MOS-Feldeffekttransistor T2 verbleibt eine Drain-Gate-Spannung von beispielsweise etwa 7 V, die hinsichtlich eines möglichen Spannungsdurchbruchs zu tolerieren sein sollte.

Diese am zusätzlichen MOS-Feldeffekttransistor T2 verbleibende Drain-Gate-Spannung kann erforderlichenfalls aber auch weiter reduziert werden, indem, wie dies aus FIG 3 ersichtlich wird, zwischen den zusätzlichen MOS-Feldeffekttransistor T2 und die Speisespannungsquelle $U_R$ wenigstens ein weiterer MOS-Feldeffekttransistor T3 eingefügt ist, dessen Gate-Elektrode mit seiner Drain-Elektrode zusammengeschaltet ist. An einem solchen weiteren MOS-Feldeffekttransistor (T3) fällt dann dessen Schwellenspannung von beispielsweise etwa 1 V ab, so daß sich die am MOS-Feldeffekttransistor T2 verbleibende Drain-Gate-Spannung entsprechend verringert.

Grundsätzlich kann zu einer weitergehenden Spannungsverringerung auch eine Mehrzahl solcher weiterer MOS-Feldeffekttransistoren in Serie zwischen den zusätzlichen MOS-Feldeffekttransistor T2 und die Speisespannungsquelle $U_R$ eingefügt sein; dabei ist ggf. durch geeignete Dimensionierung der Transistoren deren im Durch laßzustand der Schaltungsanordnung gegebener Gesamtwiderstand hinreichend klein zu halten, so daß der von den externen Gegebenheiten her erforderliche Stromfluß gewährleistet ist. Im Hinblick auf den Sperrzustand der Schaltungsanordnung sind ggf. die technologiebedingt relativ großen Toleranzen der Schwellenspannung solcher weiterer Transistoren zu berücksichtigen.

**Patentansprüche**

1. Open-Drain-MOSFET-Schaltung mit einem an seiner Gate-Elektrode mit einem Durchschalte- bzw. Sperrsignal beaufschlagten MOS-Feldeffekttransistor,

**dadurch gekennzeichnet,**
daß zwischen den MOS-Feldeffekttransistor (T1) und eine mit dessen Drain-Elektrode verbundene Speisespannungsquelle ($U_R$) mit die Drain-Gate-Durchbruchsspannung des MOS-Feldeffekttransistors (T1) überschreitender Speisespannung ein zusätzlicher MOS-Feldeffekttransistor (T2) eingefügt ist, dessen Gate-Elektrode an einer festen, die genannte Drain-Gate-Durchbruchsspannung nicht überschreitenden Betriebsspannung ($U_G$) liegt.

2. Open-Drain-MOSFET-Schaltung nach Anspruch 1,
**dadurch gekennzeichnet,**
daß zwischen den zusätzlichen MOS-Feldeffekttransistor (T2) und die Speisespannungsquelle ($U_R$) wenigstens ein weiterer MOS-Feldeffekttransistor (T3) eingefügt ist, dessen Gate-Elektrode mit seiner Drain-Elektrode zusammengeschaltet ist.

0275995

**FIG 1**

**FIG 2**

**FIG 3**